Europäisches Patentamt

European Patent Office

Office européen des brevets

(11) Publication number: **0 383 712**

**A2**

## (12) EUROPEAN PATENT APPLICATION

(21) Application number: **90480003.4**

(22) Date of filing: **03.01.90**

(51) Int. Cl.⁵: **H01L 21/285**

(30) Priority: **13.02.89 US 310280**

(43) Date of publication of application:
**22.08.90 Bulletin 90/34**

(84) Designated Contracting States:
**DE FR GB**

(71) Applicant: **International Business Machines Corporation**
**Old Orchard Road**
**Armonk, N.Y. 10504(US)**

(72) Inventor: **Ku, San-Mei**
**3 Carnelli Court**
**Poughkeepsie, N.Y. 12603(US)**
Inventor: **Rausch, Werner Alois**
**71 Judith Drive, R.D. No. 3**
**Stormville, N.Y. 12582(US)**

(74) Representative: **Klein, Daniel Jacques Henri**
**Compagnie IBM France Département de Propriété Intellectuelle**
**F-06610 La Gaude(FR)**

(54) **Method for fabricating high performance transistors with polycrystalline silicon contacts.**

(57) A method for fabricating extrinsic base transistor and resistor contacts employing doped polysilicon is disclosed herein. The method comprises rapid thermal annealing the doped polysilicon to activate the dopant in the polycrystalline layer and drive the dopant into the substrate. The rapid thermal anneal can be performed from 1000°C to 1100°C for less than 100 seconds. The annealed polysilicon contacts exhibit reduced resistance and capacitance relative to conventionally annealed contacts. The structure shown in the attached drawing illustrates the details of the polycrystalline silicon contact. The polycrystalline silicon layer (30) formed above the epitaxial layer (14) coated by a patterned insulating layer (28) defines a contact opening for subsequent emitter formation, concentric with the extrinsic base. The base contact opening (44) is made through a composite dielectric passivation layer (34, 36, 40).

FIG. 10

# METHOD FOR FABRICATING HIGH PERFORMANCE TRANSISTORS WITH POLYCRYSTALLINE SILICON CONTACTS

The present invention relates to the fabrication of high performance transistors and, more particularly, to fabrication methods employing doped polysilicon contacts wherein the resistance and capacitance of the polysilicon contacts is reduced by processing techniques.

In order to increase the performance of transistors, extensive efforts have been made to develop fabrication processes which will result in small devices, spaced as closely as possible. Increased device density improves switching speed characteristics as well as wafer productivity.

In bipolar devices, improvement in switching speed characteristics is sought, at least in part, by effecting a reduction in the base resistance, base-collector junction capacitance and collector-substrate capacitance.

The primary technique employed in the prior art to reduce size and improve device yield is the so-called "self-alignment technique." Typical of the prior art schemes using self-alignment is the use of polysilicon base contacts self-aligned to the emitter contact. For example, see the following references:

An article by Ho et al "Stacking Poly-Silicon Devices for High Density LSI," published May 1979 in Vol. 21, No. 12 of the IBM Technical Disclosure Bulletin. Ho et al describes a bipolar process wherein polysilicon base contacts are used to self-align a polysilicon emitter contact, the latter being used as a source of impurity for form the emitter region.

Likewise, U.S. Patent No. 4,157,269 to Ning et al describes the use of self-aligning polysilicon base contacts separated from the emitter contact by an oxide layer.

An article entitled "Method for Reducing the Emitter-Base Contact Distance in Bipolar Transistors" by C. G. Jambotkar appearing in Vol. 19, No. 12, May 1977, of the IBM Technical Disclosure Bulletin describes two processes for reducing emitter-base contact distance using horizontal layers of insulation for separation therebetween and polysilicon as either base or emitter contact. In similar manner, U.S. Patent No. 4,160,991 to Anantha et al describes another arrangement aimed at reducing the spacing between emitter and polysilicon base contacts.

An article entitled "A New Polysilicon Process for a Bipolar Device-PSA Technology" appearing in the IEEE TRANS-ACTIONS ON ELECTRON DEVICES, Vol. ED-26, No. 4, April 1979, is directed to a polysilicon self-aligned (PSA) method.

One preferred polycrystalline silicon deposition process is thermal decomposition of silane either at reduced pressure and temperatures from 600°C to 700°C or at atmospheric pressure and temperatures of the order of 1000°C to 1200°C. In most cases, the doping element is introduced during the deposition process. However, better control of the total amount of impurity is obtained if the conductivity imparting impurity is incorporated into the film after the deposition of the film by ion implantation. In that case, a post ion implantation annealing up to 1100°C is needed to assure uniform impurity distribution throughout the films.

The following patents are examples of ion implanted polycrystalline silicon devices and methods to form them.

U.S. Patent No. 4,561,907 of Raicu, for "Process for Forming Low Sheet Resistance Polysilicon Having Anisotropic Etch Characteristics" teaches depositing a highly doped polycrystalline silicon layer on a silicon substrate. The polycrystalline silicon is implanted with phosphorous which is then followed by rapid thermal annealing (RTA).

The process of Raicu yields a recrystallized layer of doped polysilicon after the rapid thermal annealing process but does not teach or concern the effects of annealing on the fabrication of high performance transistor contacts.

U.S. Patent No. 4,431,460 of Barson et al for "Method of Producing Shallow Narrow Base Bipolar Transistor Structures Via Dual Implantations of Selected Polycrystalline Layer" describes a two-step process for doping a polycrystalline silicon layer on a monocrystalline silicon surface. The polycrystalline material is first doped with boron by ion implantation followed by annealing, which is then followed by ion implantation of arsenic into the polycrystalline layer with another anneal to fully drive the boron and arsenic into the monocrystalline silicon to form the base and the emitter of an NPN transistor. These anneals are furnace anneals at conventional temperatures and time.

U.S. Patent No. 4,467,519 of Glang, Ku and Schmitt for "Process for Fabricating Polycrystalline Silicon Film Resistors" describes formation of resistors of an NPN bipolar transistor structure. The polycrystalline silicon is treated by ion implantation of boron into the polycrystalline silicon. Then thermal annealing follows to drive boron into the external (extrinsic) base region. Next, portions of the polycrystalline silicon are removed to form external base contact and resistors in the polycrystalline layer.

U.S. Patent No. 4,610,730 of Harrington et al for "Fabrication Process for Bipolar Devices" describes a process for the fabrication of semiconductor device using relatively low temperatures for critical oxidation and ion implanting steps. Annealing is taught as a multi-step process with a low temperature (550°C) step for a long duration followed by a higher temperature step with a somewhat shorter duration, finalized by a still higher temperature step for a very short duration.

U.S. Patent No. 4,534,806 of Magdo for "Method for Manufacturing Vertical PNP Transistor with Shallow Emitter," describes a polysilicon layer which is deposited over the structure including the intrinsic base region. The polysilicon layer is ion implanted with boron. The preferred method for effecting drive-in of the P type dopant is by thermal annealing. Thermal heat treatment at a temperature of from about 900°C to about 1100°C for a period of about 90 minutes at the lower temperature to about 2 minutes at the higher temperature has been found to be suitable." There is no teaching or suggesting for using rapid thermal annealing.

None of these patents teach or suggest a method for reducing the resistance and capacitance of a polysilicon extrinsic contacts by controlling with rapid thermal annealing the annealing and diffusion of boron from the doped polysilicon into the monocrystalline substrate.

In accordance with the principles of the present invention, there is described a method for reducing extrinsic contact resistance and capacitance of high performance transistor contacts by employing rapid thermal anneal of the doped polysilicon.

For a high performance bipolar device, the extrinsic base contact is formed by a process according to the following:

1. A thin film of intrinsic polysilicon is blanket deposited on top of a dielectric layer which dielectric layer has openings therein exposing the single crystal epitaxial substrate into which the intrinsic base is to be formed.

2. Boron is then implanted into the polysilicon by conventional implantation means.

3. A CVD oxide layer is deposited over the polysilicon and the structure limits of the extrinsic base are defined by photolithography.

4. The boron is then activated by rapid thermal annealing which anneal has a shallower diffusion depth and hence smaller capacitance.

Rapid thermal annealing increases the boron activation in the recrystallized layer and drives the boron into the underlying single crystal epitaxy to a shallow depth of about 200 nanometers. The recrystallization decreases the sheet resistance of the polysilicon layer and the shallow drive-in reduces the capacitance of the extrinsic base. Thus the process involves heating the polycrystalline silicon and the underlying epitaxial layer to a high temperature so that there is a sufficient increase in solid solubility of boron that is incorporated into the crystal structure of the underlying epitaxial layer. At the same time, the polycrystalline material is converted into monocrystalline silicon by solid phase epitaxial recrystallization which results in elimination of carrier trapping and dopant segregation at grain boundaries and an increase in hole mobility.

The foregoing and other objects, features and advantages of the invention will be apparent from the following more particular description of the invention as illustrated in the accompanying drawings.

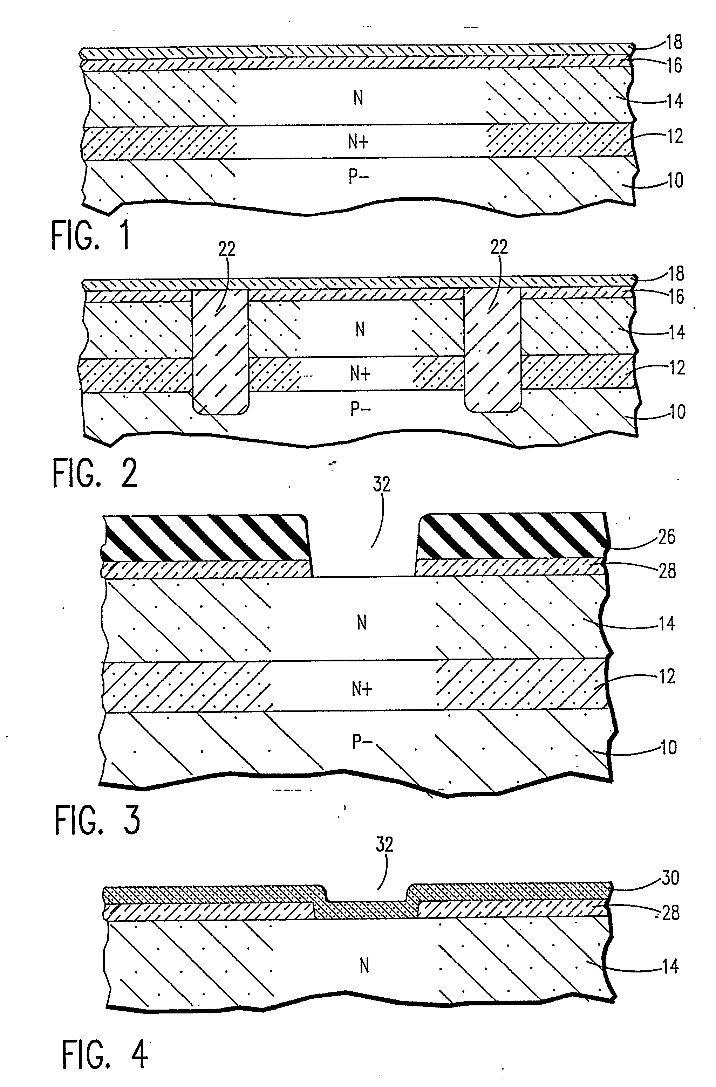

Figures 1 - 10 are cross-sectional views in the fabrication process for a high performance bipolar transistor in accordance with the principles of the present invention.

Referring now to Figure 1, the device is fabricated by starting with a wafer or substrate 10 of P-monocrystalline silicon. The manufacturing process of this series of FIGURES results in the fabrication of an NPN bipolar transistor. It should, however, be evident to those skilled in the art that the conductivity types shown in the drawing is selected for illustrative purposes only and that the opposite conductivity type can be used. Further, the concentration of impurities can be increased or decreased as desired. The substrate 10 is fabricated, for example, by pulling a monocrystalline rod from a suitable melt containing a P-type material such as boron and using a seed crystal having a <100> crystallographic orientation. The resulting rod is then sliced into very thin wafers which also have the surface crystallographic orientation of <100>. The P- silicon wafer has preferably a resistivity of 10-20 ohms-centimeter.

In Figure 1, a region (not shown) of conductivity different from the substrate is then formed in the substrate 10. The region is preferably formed by ion implantation techniques but could alternatively be formed by the conventional diffusion processes. This region is formed,in the case of the silicon substrate, by first obtaining an insulating layer of silicon dioxide on the semiconductor surface by thermal oxidation. The preferred thickness of the silicon dioxide is 25 nanometers. This thickness acts as a screen for the subsequent ion implantation step. The oxidized silicon wafer is then positioned in an ion implantation apparatus and subjected to arsenic ions at 50KeV and $1 \times 10^{16} \, cm^{-2}$ dosage to obtain an N+ layer 12. The structure is removed from the ion implanting apparatus and placed into a suitable heating apparatus wherein the ion implanted layer is heated, for example, at approximately 1100°C for 5 minutes in oxygen, then 70 minutes in argon, 55 minutes in steam, and 5 minutes in oxygen. The effect of this heat treatment is to drive the arsenic further into the P- substrate and to further oxidation of the surface. The silicon dioxide surface layer is then removed by a suitable etching procedure.

The structure is then placed in an epitaxial growth chamber wherein epitaxial layer 14 is formed, as shown in Figure 1. Although the epitaxial layer may be any desired thickness, for purposes of the high performance devices of the type involved in the present invention, the thickness should be less than about 1.5 microns. Typically, the thickness of epitaxial layer 14 is about 1.2 microns. Layer 14 is grown onto substrate 10 by conventional techniques, such as the use of $SiCl_4/H_2$ or $SiH_4/H_2$ mixtures at about 1000°C to 1200°C.

After formation of epitaxial layer 14, a layer of silicon dioxide is formed over the epitaxial layer. This layer is shown at 16 in Figure 1. A layer of silicon nitride 18 is then formed over the layer of silicon dioxide and conventional photolithography and etching techniques are employed to selectively remove silicon nitride and silicon dioxide. With openings formed in the layers of silicon nitride and silicon dioxide, N epitaxial layer 14 is etched to form the trenches through the N+ region 12, as shown in Figure 2.

After forming the trenches in epitaxial layer 14, layer 22 is formed by filling the trench with an insulating material, as shown in Figure 2 to a level corresponding approximately to the top surface of oxide layer 24.

It will be recognized by those skilled in the art that processing to this point has been by conventional techniques.

Referring now to Figure 3, a dielectric layer 28 is provided over the semiconductor body covering those regions outside the active transistor region and open to those designated as the extrinsic base and resistor contact regions. The layer may be a chemical vapor deposited silicon layer of about 50 to 1000 nanometers in thickness. The preferred process for depositing such a layer is chemical vapor deposition. Alternatively, the dielectric layer 28 may be comprised of a combination of layers of silicon dioxide and silicon nitride or other materials. The openings in the layer are formed by conventional lithography and photoresist 26 masking procedures.

In Figure 4, an undoped polycrystalline silicon layer 30 is then formed uniformly over the surface of the silicon body wherein there are openings to the monocrystalline silicon body. The polycrystalline silicon body makes ohmic contact to these regions which are designated to be the extrinsic base regions 32. Elsewhere, the polycrystalline silicon layer is formed over the insulating layer 28. The layer may be deposited by pyrolysis of silane at 625°C.

The operative thicknesses of the polycrystalline silicon layer 30 is between about 30 to 500 nanometers (with about 300 nanometers being preferred).

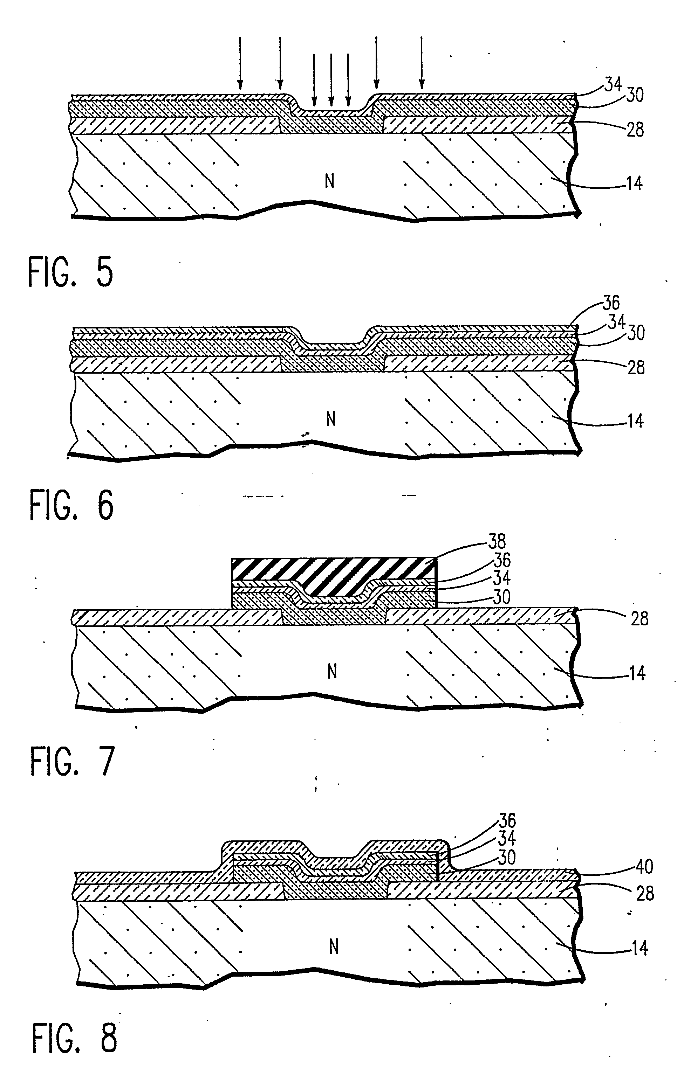

Referring to Figure 5, a thin screen oxide 34 is then grown over this polysilicon layer 30. This screen oxide is approximately 100nm.

P type boron dopant is then ion implanted into the intrinsic polysilicon through the screen oxide to render the polysilicon film P+ to the desired doping concentration. The preferred doping level is between about $5 \times 10^{19}$ to $5 \times 10^{20}$ atoms/cm$^3$.

In Figure 6 an additional film 36 of CVD oxide is deposited over the screen oxide 34 to be used as an etch-stop during the subsequent polysilicon structuring of the extrinsic base and insulating layer between subsequent polysilicon films.

Referring now to Figure 7, a photolithography masking step is then used to define the extrinsic base area. A photoresist mask 38 is blanket deposited over the additional oxide layer. The photoresist is then exposed, developed, and removed over those areas where the extrinsic base will not be formed.

Then, a dry etch (preferably RIE) as described above or wet etch for forming the trenches is now performed. During this step, the oxides over the polysilicon, as well as, the polysilicon, itself, are removed, except in the extrinsic base region. Over-etch of these areas may be desirable to remove the polysilicon completely and avoid the shorting problems of polysilicon rails.

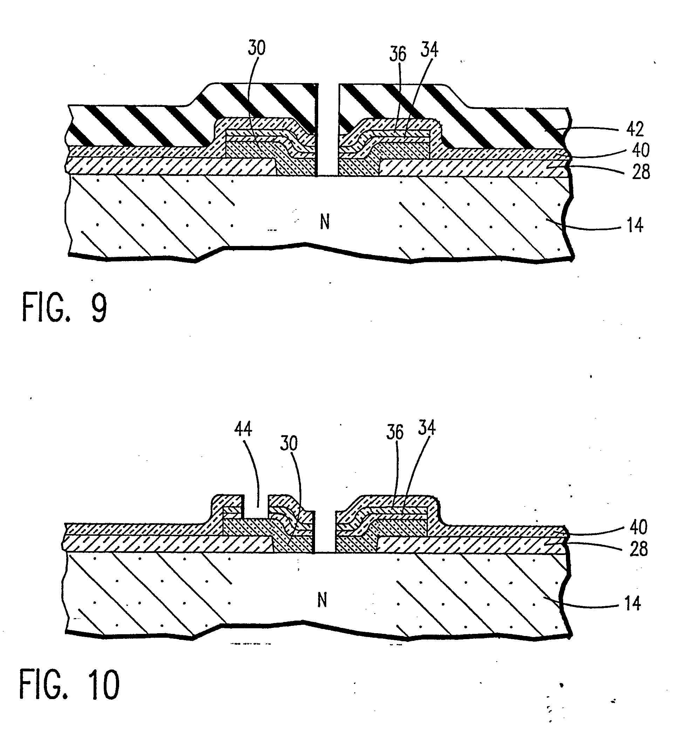

In Figure 8, the resist layer 38 over the extrinsic base area is stripped off. Optionally, a layer 40 of LPCVD $Si_3N_4$ can be blanket deposited over the extrinsic base and wafer. The standard self-aligned emitter/intrinsic base is then defined by a lithography and RIE step to remove the extrinsic base polysilicon layer over the emitter/intrinsic base region as shown in Figure 9.

The polycrystalline silicon film is now heat-treated or annealed at temperatures above the film deposition temperature. Specifically, it has been found with the subject invention that it is preferred to anneal the polysilicon at elevated temperatures for short duration to achieve lower resistance and capacitance of the extrinsic base. For the subject embodiment, annealing is recommended at 1000°C-1100°C for a few seconds to activate the boron and drive the boron into the single crystal N-epitaxial region. In practice, it has been found that a 1050°C rapid anneal for 15 seconds has reduced the extrinsic base resistance from about 160 ohms/square to 115 ohms/square with a slight decrease in the junction depth. Hence, there was achieved a reduction of extrinsic base sheet resistance and a lowering of the base junction capacitance.

While it will be recognized by those skilled in the art that the shallower junction will yield a reduced capacitance, in theory, the resistance should be increased due to the shallower boron doped region. However, it has been observed by the inventors that the resistance decreases for two reasons. First, the maximum boron concentration in the single crystal substrate is increased due to the increased boron solubility at the higher rapid thermal anneal temperature. The second mechanism for sheet resistance reduction is solid phase epitaxial recrystallization of the polycrystalline silicon layer to monocrystalline silicon. Conventional techniques are now used to complete the processing of the device.

The intrinsic P base region and the N + emitter region are now formed. This structure may be formed by successive ion implantations or diffusions. However, it is preferred to use an ion implantation. The polycrystalline silicon layer remains as the emitter contact to the emitter region in the final structure.

Contact openings 44 are made through the insulating layer to the extrinsic base contact regions and the resistor regions. A blanket metallization is accomplished through conventional metal evaporation techniques. However, a metal silicide layer (e.g. platinum silicide) can be formed to prevent metal penetration into the silicon. Transition metals, aluminum, aluminum-copper and the like are utilized as the suitable metal. The metal layer is delineated by conventional lithography and etching techniques to form the metal contact to the extrinsic base layer, metal contact to the emitter and the metal contacts to the resistor in the polycrystalline silicon layer.

## Claims

1. A process for fabricating transistor and resistor contacts employing doped polysilicon contacts as the extrinsic contacts to the transistor substrate comprising the steps of
    a) depositing polycrystalline silicon on said substrate in those areas where the extrinsic contacts are to be made,
    b) implanting dopant into said polycrystalline,
    c) anneal said structure at 1000°C-1100° for less than one minute to activate the boron and drive the boron into the substrate to form the shallow extrinsic contact.

2. A process according to Claim 1 wherein the dopant is selected from the group of arsenic, phosphorous or boron.

3. A process according to Claim 1 wherein said boron is implanted 20-50 KEV to a concentration $3\times10^{20}$cm$^{-3}$ in the polycrystalline silicon.

4. A process according to Claim 1 wherein said anneal is performed at a temperature of about 1050°C for about 15 seconds.

5. A process according to Claim 3 wherein said temperature is obtained with an upramp and downramp of about 10°C/second.

6. A process for fabricating bipolar transistors and resistor employing polysilicon base contacts said base contacts being doped to act as a self-aligned impurity source to form the extrinsic base region in the monocrystalline silicon substrate comprising the steps of:
    a) depositing a layer of insulating material on the monocrystalline silicon substrate said insulating layer having openings therein for contacting said substrate,
    b) depositing a blanket layer of polycrystalline silicon over said insulating layer and openings,
    c) depositing an oxide layer over said polycrystalline layer,
    d) implanting boron dopant into said polycrystalline layer,
    e) deposit a blanket layer of photoresist over said oxide layer,
    f) expose, develop and remove said photoresist over said oxide in those areas other than the extrinsic base area,
    g) dry etch to remove said exposed oxide and polycrystalline layers,
    h) anneal said structure at 1000°C-1100°C for less than one minute to activate the boron and drive the boron into the monocrystalline silicon to form the extrinsic base.

7. A process according to Claim 6 wherein said insulating layer is silicon dioxide.

8. A process according to Claim 6 wherein said insulating layer is a combination of silicon dioxide and silicon nitride.

9. A process according to Claim 6 wherein said polycrystalline silicon is deposited by CVD.

10. A process according to Claim 6 wherein said oxide layer is a double layer of a thermal oxide with a chemical vapor deposited oxide.

11. A process according to Claim 6 wherein said boron is implanted 20-50 KEV to a concentration $3\times10^{20}$cm$^{-3}$ in the polycrystalline silicon.

12. A process according to Claim 6 wherein the dry etch is reactive ion etch.

13. A process according to Claim 6 wherein the second dry etch is performed to open a window in the device stack for self-aligning the emitter.

14. A process according to Claim 6 wherein said anneal is performed at a temperature of about 1050°C for about 15 seconds.

15. A process according to Claim 6 wherein said temperature is obtained with an upramp and downramp of about 10°C/seconds.

FIG. 1

FIG. 2

FIG. 3

FIG. 4

FIG. 5

FIG. 6

FIG. 7

FIG. 8

FIG. 9

FIG. 10

FI 9 88 017